# EUROPÄISCHE PATENTSCHRIFT

(11) **EP 2 253 022 B1**
(45) Veröffentlichungstag und Bekanntmachung des Hinweises auf die Patenterteilung: **12.12.2012**
(21) Anmeldenummer: 09716540.1
(22) Anmeldetag: 03.03.2009
(51) Int. Cl.: H01L 31/048

(54) **Solarmodul mit erhöhter Biegesteifigkeit**
Solar module with enhanced bending stiffness
Module solaire de rigidité à la flexion augmentée

(30) Priorität: 03.03.2008 DE 102008012286; 14.05.2008 DE 202008006549 U
(43) Veröffentlichungstag der Anmeldung: 24.11.2010
(73) Patentinhaber: Fraunhofer-Gesellschaft zur Förderung der angewandten Forschung e.V., 80686 München (DE)
(72) Erfinder: BUSCH, Michael, 06130 Halle (DE); BAGDAHN, Jörg, 06366 Köthen (DE)
(74) Vertreter: Rösler, Uwe
(86) Internationale Anmeldenummer: PCT/DE2009/000305
(87) Internationale Veröffentlichungsnummer: WO 2009/109180

(56) Entgegenhaltungen:
- EP-A- 0 474 349
- EP-A2- 2 028 696
- DE-A1-102005 053 363
- JP-A- 1 212 480
- JP-A- 9 153 634
- US-A- 5 972 732
- US-A1- 2007 095 386

## Beschreibung

### Technisches Gebiet

Die Erfindung bezieht sich auf ein Solarmodul mit einer flächig ausgebildeten Solarzellenanordnung, an deren Rückseite eine Rückseitenkonstruktion und an deren Vorderseite eine strahlungstransparente Frontscheibe vorgesehen sind, mit einer die Solarzellenanordnung zwischen Rückseitenkonstruktion und Frontscheibe umgebenden, erstarrungsfähigen und mechanische Lasten übertragenden Vergussmasse, die die Frontscheibe mit ihrer der Rückseitenkonstruktion zugewandten Oberfläche ganzflächig mit der Rückseitenkonstruktion verbindet und die Solarzellenanordnung vollständig umschließt.

### Stand der Technik

Solarmodule sind photovoltaische Bauelemente zur direkten Erzeugung von elektrischem Strom aus Sonnenlicht. Schlüsselfaktoren für eine kosteneffiziente Erzeugung von Solarstrom sind die Herstellkosten und die Haltbarkeit der Solarmodule.

Solarmodule bestehen üblicherweise aus einem Verbund aus einer Frontscheibe, den verschalteten Solarzellen, die von einem Einbettmaterial umschlossen sind, und einer Rückseitenkonstruktion. Eine verbreitete Variante von Solarmodulen wird für die Handhabung und spätere Halterung noch mit Aluminiumprofilen versehen, die umlaufend als Rahmen und teilweise auch unterstützend als Verstrebungen angebracht werden. Die einzelnen Elemente eines Solarmoduls haben dabei folgende Funktionen zu erfüllen:

Die Frontscheibe, meist aus Glas, etwa 3-4mm dick, dient dem Schutz vor mechanischen und Witterungseinflüssen und liefert einen Teil der mechanischen Stabilität des Moduls. Sie muss hoch transparent sein, vorzugsweise aus Weißglas mit 90-92% Transmissionsgrad im oberen Spektralbereich, um Absorptionsverluste im optischen Spektralbereich von etwa 300 nm bis 1500 nm möglichst gering und damit den Wirkungsgrad der üblicherweise eingesetzten Silizium-Solarzellen möglichst hoch zu halten.

Das Einbettmaterial, häufig werden hierfür Ethylen-Vinylacetat-Folien oder kurz EVA-Folien verwendet, dient zur Einbettung der verschalteten Zellen und der Verklebung des gesamten Modulverbundes. Derartige Einbettungen sind jedoch nicht in der Lage mechanische Belastung zu übertragen, ein Aspekt, auf den im Weiteren noch eingegangen wird.

Auf der Modulrückseite wird zum Schutz der Solarzellen und des Einbettmaterials vor Feuchtigkeit und Sauerstoff, als mechanischer Schutz und als elektrische Isolation eine Verbundfolie, meist bestehend aus Polyvinylfluorid (PVF) und Polyethylenterephthalat (PET) oder aus PVF und Aluminium, verwendet. In einigen Fällen wird auch auf der Rückseite wie auf der Frontseite eine Glasscheibe eingesetzt.

Eine verbreitete Technologie zur Einbettung stellt die Vakuumlaminierung dar, da durch das Vakuum beim Laminieren die Bildung von Luftblasen weitgehend vermieden wird. EVA schmilzt während des Laminierens bei etwa 150°C, umfließt die verschalteten Solarzellen und wird thermisch vernetzt.

Die eingesetzten Kapselungs- bzw. Einbettungsmaterialien sollten dabei gute Barriereeigenschaften gegen Wasserdampf und Sauerstoff aufweisen, zumal durch Wasserdampf oder Sauerstoff korrosionsbedingte Schädigungen an Metallkontakten auftreten und es zur Degradation des EVA-Materials kommt. Somit sollten die Vorder- und Rückseite des Solarmoduls hohe Witterungsstabilität aufweisen und die eingebetteten Solarzellen durch Barrierewirkung z. B. gegen Wasserdampf und Sauerstoff vor Korrosion schützen.

Grundsätzlich müssen Solarmodule für ihren Einsatz, z. B. auf Hausdächem, eine hohe mechanische Stabilität, insbesondere eine hohe Biegesteifigkeit und Biegefestigkeit, aufweisen, um die im Betrieb möglichen Lasten, z. B. Wind- und Schneelasten, schadlos ertragen zu können. Die mechanische Stabilität bekannter Solarmodule kann durch seine Rückseite, seine Vorderseite und/oder durch weitere zusätzliche Unterstützungen, z. B. in Form von Aluminiumrahmen, Aluminiumverstrebungen, eine stabile Auflagekonstruktion, die ein Durchbiegen des Moduls unter Last verhindert, gewährleistet werden.

Darüber hinaus sollten Solarmodule sehr lange Betriebszeiten erreichen, um die Rentabilität zu gewährleisten. Heute übliche Anforderungen an die Lebensdauer der Solarmodule sind mindestens 25 Jahre, Tendenz steigend. Im Betrieb unterliegen die Solarmodule hohen mechanischen Belastungen, z. B. durch Wind- und Schneelasten, sowie durch zyklisch auftretende Temperaturschwankungen, die von 80°C bei voller Sonneneinstrahlung bis unterhalb des Gefrierpunkts liegen können.

Hohe Material- und Fertigungskosten, bedingt bspw. durch spezielles Frontglas, spezielle Verbundfolie für die Rückseite, Vakuumlaminierung, Aluminiumrahmen etc., die erforderlichen manuellen Arbeiten, bspw. Verlöten der elektrischen Leitungen, Montage und Kontaktierung der Anschlussdosen, und die relativ langen Prozesszeiten, z. B. für die Laminierung und Vernetzung des EVA, führen zu einem vergleichsweise hohen Anteil der Kosten für den Modulbau an den Gesamtkosten im zweistelligen Prozentbereich.

Durch die relativ dicke Frontglasscheibe weisen konventionelle Solarmodule zudem ein hohes Gewicht auf, das wiederum stabile und teure Halterungskonstruktionen erforderlich macht.

Ein weiterer wichtiger Punkt ist die Wärmeabfuhr. Bei voller Sonnenbestrahlung heizen sich die Module auf bis zu 80°C auf, was eine Verringerung des Wirkungsgrades der Solarzellen zur Folge hat.

Zwar existieren verschiedene Vorschläge zu Verringerung der Herstellungskosten der Solarmodule durch kostengünstigere Komponenten und Herstellungsverfahren, doch sind auch diese Vorschläge nicht richtig zielführend. Von Bedeutung für die Erfindung sind neben möglichen weiteren das Patent EP 325369 A2 (Abk. EP) und die Offenlegungsschrift DE 10101 770 A1 der Bayer AG (Abk. DE).

In EP 325369 A2 wird ein Photovoltaik-Modul beschrieben, das auf einer Einbettung eines "Photovoltaik-Panels" in ein reaktives Elastomer beruht. Das Photovoltaik-Panel besteht aus einer Kombination aus einer Schicht aus transparentem Material, einer Anordnung verschalteter photovoltaischer Zellen und einer Rückseitenschicht, die jedoch keine mechanische Stabilität bietet.

In DE 10 101 770 A1 wird ein Solarmodul beschrieben, bei dem die Solarzellen vollständig von einem Polyurethanmaterial umspritzt sind, entweder von ein und demselben oder von zwei verschiedenen Polyurethanmaterialien. Das transparente Polyurethan ist elastomerartig weich, so dass seine Biegesteifigkeit vernachlässigbar ist. Dies hat eine nur geringe Biegesteifigkeit des gesamten Solarmoduls zur Folge. Eine weitere beschriebene Variante eines Solarmoduls ist die, bei der die Solarzellen auf einem als Modulrückseite dienenden Formteil fixiert sind, auf das dann ein transparentes Polyurethan aufgespritzt wird. Bei dieser Variante kann eine höhere Biegesteifigkeit des Solarmoduls durch Verwendung eines biegesteifen Formteils als Modulrückseite, bspw. ein mit Glasfasern verstärktes Polycarbonat, erreicht werden. Grundsätzlich werden Solarmodule angestrebt, die über eine hohe mechanische Stabilität verfügen. Ein hoch stabiles Modul, typischerweise mit einer Fläche von etwa 1,40m², sei ein solches, das ohne weitere zusätzliche Unterstützungen, wie Aluminiumrahmen, Aluminiumverstrebungen, eine stabile Auflagekonstruktion, die ein Durchbiegen des Moduls unter Last verhindert, etc., also nur durch sich selbst tragend, allen in den einschlägigen Normen vorgeschriebenen mechanischen Belastungstests Stand hält.

Um diese für ein Solarmodul mit hoher mechanischer Stabilität definierten Anforderungen zu erreichen, muss entweder die Rückseite des Solarmoduls relativ dick ausgeführt werden, was mit einer schlechten Wärmeableitung sowie einem höheren Gewicht des Solarmoduls einher geht, oder die Glasplatte muss relativ dick ausgeführt werden. Beide Fälle führen zu einem hohen Gewicht des Moduls.

Ferner ist der DE 102 30 392 A1 ein Solarmodul zu entnehmen, das eine zwischen einer aus Acrylglas bestehenden oberen und unteren Platte eine Solarzellenanordnung vorsieht, die von einer Füllmasse umgeben ist, die zugleich die obere mit der unteren Platte verbindet. Diese Anordnung führt für großflächige, robuste Solarmodule, die zum Zwecke solargespeister Energiequellen mit typischen Flächengrößen von wenigstens einem Quadratmeter bspw. für die Dachmontage an Gebäuden vorgesehen werden, zu hohen Modulgewichten.

In ähnlicher Weise kann aus der DE 198 34 016 A1 ein vergleichbares Solarmodul entnommen werden, das eine aus einem gegossenen oder extrudierten PMMA-Material bestehende Rückseitenkonstruktion sowie eine aus Plexiglas bestehende Deckplatte vorsieht, zwischen denen eine Solarzellenanordnung eingebracht und mit einem strahlungstransparenten Silgel verfüllt ist. Diese Solarmodule können durch die Hohlkammerstruktur der Rückseitenkonstruktion biegesteif und zugleich leicht ausgeführt werden, dafür muss aber die Rückseitenkonstruktion sehr dick ausgeführt werden, was mit einem erheblichen Wärmestau verbunden ist und sich negativ auf den Wirkungsgrad auswirkt. Die Wärmeabfuhr ist bei diesen Elementen nur dann möglich, wenn die Hohlkammern der Rückseitenkonstruktion gezielt für die Wärmeabfuhr verwendet werden, was jedoch bei den für die Dachmontage an Gebäuden vorgesehenen Module meist nicht realisiert werden kann.

Aus aus der US 2007/095386 A1 geht ein Solarmodul mit einer Frontscheibe, Solarzellenanordnung und einer als separates Modul ausgeführten Rückseitenkonstruktion hervor, zu der getrennt stromleitende Teile vorgesehen sind, die mit der Solarzellenanordnung kontaktiert sind und die Rückseitenkonstruktion seitlich überrragen.

Die Druckschrift EP 2 028 696 A2, die zur vorliegenden Erfindung als nachveröffentlichte Druckschrift anzusehen ist beschreibt ein Solarzellenmodul mit einer flächig ausgebildeten Solarzellenanordnung, an deren Rückseite eine Rückseitenkonstruktion und an deren Vorderseite eine strahlungstransparente Frontscheibe vorgesehen sind, mit einer die Solarzellenanordnung zwischen Rückseitenkonstruktion und Frontscheibe umgebenden, erstarrungsfähigen und mechanische Lasten übertragenden Vergussmasse, die die Frontscheibe mit ihrer der Rückseitenkonstruktion zugewandten Oberfläche ganzflächig mit der Rückseitenkonstruktion verbindet und die Solarzellenanordnung vollständig umschließt, wobei die Rückseitenkonstruktion als separates Modul ausgebildet ist, in die eine metallische elektrische Anschlussstruktur für eine elektrische Verbindung mit der Solarzellenanordnung derart integriert ist, dass zumindest ein Teilbereich der elektrischen Anschlussstruktur vollständig von dem Kunststoffträgermaterial umgeben ist und zumindest ein anderer Teilbereich der elektrischen Anschlussstruktur einen der Solarzellenanordnung zugewandten freien Kontaktbereich aufweist.

Die Druckschrift US 5,972732 beschreibt eine schichtförmig aufgebaute photovoltaische Solarzelle, die im Wege der Laminat-Technik hergestellt wird.

### Darstellung der Erfindung

Aufgabe der Erfindung ist die Entwicklung von Solarmodulen mit hoher mechanischer Stabilität, insbesondere hoher Biegesteifigkeit und Biegefestigkeit, so dass z. B. ein Modul dieser Bauart mit einer Fläche von etwa 1,40m² ohne weitere zusätzliche Unterstützungen wie Aluminiumrahmen, Aluminiumverstrebungen, eine stabile Auflagekonstruktion, die ein Durchbiegen des Moduls unter Last verhindert, etc., also nur durch sich selbst, allen in den einschlägigen Normen vorgeschriebenen mechanischen Belastungstests Stand hält, auf der Basis von photoaktiven Elementen. Das Solarmodul soll insbesondere kostengünstig, robust gegen äußere Einflüsse, von langer Lebensdauer sein und eine hohen Wirkungsgrad auch bei hohen Sonnenstrahlungstemperaturen gewährleisten.

Die der Erfindung zugrunde liegende Aufgabe wird durch den Ansprüchen 1 und 2 gelöst. Den Erfindungsgedanken vorteilhaft weiterbildende Merkmale sind Gegenstand der Unteransprüche sowie der weiteren Beschreibung unter Bezugnahme auf die Ausführungsbeispiele zu entnehmen.

Ein lösungsgemäßes Solarmodul mit einer flächig ausgebildeten Solarzellenanordnung, an deren Rückseite eine Rückseitenkonstruktion und an deren Vorderseite eine strahlungstransparente Frontscheibe vorgesehen sind, mit einer die Solarzellenanordnung zwischen Rückseitenkonstruktion und Frontscheibe umgebenden, erstarrungsfähigen und mechanische Lasten übertragenden Vergussmasse, die die Frontscheibe mit ihrer der Rückseitenkonstruktion zugewandten Oberfläche ganzflächig mit der Rückseitenkonstruktion verbindet und die Solarzellenanordnung vollständig umschließt, wobei die Rückseitenkonstruktion als ein separates Modul, in Form eines mittels Spritzgießen, Spritzprägen oder Pressen hergestellter Kunststoffträgers ausgebildet ist und der Kunststoffträger eine in den Kunststoffträger integrierte, metallische elektrische Anschlussstruktur für eine elektrische Verbindung mit der Solarzellenanordnung derart vorsieht, dass zumindest ein Teilbereich der Anschlussstruktur vollständig von dem Kunststoffträgermaterial umgeben ist und zumindest ein anderer Teilbereich der Anschlussstruktur einen der Solarzellenanordnung zugewandten freien Kontaktbereich aufweist, zeichnet sich dadurch aus, dass die Solarzellenanordnung zwischen der Frontscheibe und der Rückseitenkonstruktion längs oder nahe dem Bereich der sich bei Durchbiegung des Solarmoduls einstellenden neutralen Biegeebene angeordnet ist.

In einer alternativen lösungsgemäßen Ausbildungsform besteht die als separates Modul ausgebildete Rückseitenkonstruktion aus einem biegesteifen keramischen oder organischen Flächenelement, in das gleichfalls eine metallische elektrische Anschlussstruktur für eine elektrische Verbindung mit der Solarzellenanordnung integriert ist, wobei zumindest ein Teilbereich der elektrischen Anschlussstruktur vollständig von dem Material der Rückseitenkonstruktion umgeben ist und zumindest ein anderer Teilbereich der elektrischen Anschlussstruktur einen der Solarzellenanordnung zugewandten freien Kontaktbereich aufweist. So dienen in einer bevorzugten Ausführungsvariante eines Solarmoduls wenigstens ein freier Kontaktbereich der Herstellung eines elektrischen Kontaktes zur Solarzellenanordnung und ein weiterer freier Kontaktbereich dem elektrischen Anschluss des Solarmoduls an einen äußeren Verbraucherkreis, über den die Solarenergie abgegriffen werden kann.

Der hybride - hybrid bedeutet hier, dass mehrere unterschiedliche Materialien vorteilhaft einen Materialverbund bilden - Aufbau der Rückseitenkonstruktion trägt zu einer verbesserten mechanischen Flächensteifigkeit bei, sodass insbesondere großflächige Solarmodule von einem Quadratmeter Größe und mehr in einem weit geringerem Maße Flächendeformationen unterworfen sind als konventionelle Solarmodule. Die Einbringung und Ausbildung der elektrischen Anschlussstruktur innerhalb der Rückseitenkonstruktion sind unter Maßgabe sowohl der elektrischen Verbindung der zwischen der Rückseitenkonstruktion und der Deckplatte einzubringenden Solarzellenanordnung, als auch zu Zwecken einer baulichen Flächenversteifung, vergleichbar mit einer Armierung, vorzunehmen. Beispielsweise bietet es sich hierfür an, zumindest Teilbereiche der elektrischen Anschlussstruktur, die von dem Material der Rückseitenkonstruktion vollständig umgeben sind, bandförmig, gitterförmig und/oder strangprofilartig auszubilden, wodurch die elektrische Anschlussstruktur selbst eine verbesserte Biegesteifigkeit erfährt.

Neben dem Vorsehen einer metallischen Anschlussstruktur bietet es sich in vorteilhafter Weise überdies an, weitere die Flächensteifigkeit der Rückseitenkonstruktion erhöhende Vorkehrungen zu treffen, indem zusätzliche Stützstrukturen in die Rückseitenkonstruktion eingebracht werden, die nicht notwendigerweise aus einem elektrisch leitenden Material, wie Metall, sondern bspw. aus einem oder mehreren der nachfolgenden Materialien bestehen: Glas, Keramik, Kunststoff oder faserverstärkter Verbundwerkstoff. Eine derartige zusätzliche Stützstruktur ist somit ebenso wie die elektrische Anschlussstruktur aus einem anderen Werkstoff gefertigt als das Material der Rückseitenkonstruktion und trägt ihrerseits zu einem hybriden Aufbau der Rückseitenkonstruktion bei.

Das Solarmodul besteht somit in einer Ausführungsform aus einem mittels Spritzguss, Spritzprägen oder Pressen hergestellten leichten, mechanisch stabilen Kunststoffträger mit wenigstens der vorstehend erläuterten elektrischen Anschlussstruktur auf der Rückseite, einer transparenten Frontscheibe, z. B. aus Glas, Glaskeramik oder einem transparenten Kunststoff, z. B. auf Basis von PMMA, auf der Frontseite, den verschalteten und kontaktierten Solarzellen im Zwischenraum zwischen Frontscheibe und Kunststoffträger sowie einer den Kunststoffträger und die Frontscheibe verklebenden, den Zwischenraum zwischen Kunststoffträger und Frontscheibe blasenfrei ausfüllenden Klebeschicht, die dabei zugleich die Solarzellen und das Kontaktsystem verkapselt.

Betrachtet man ein Solarmodul mechanisch als Platte, so nimmt die Biegesteifigkeit mit der dritten Potenz der Plattendicke zu. Die Dicke des Solarmoduls summiert sich aus der Dicke des Kunststoffträgers, der Dicke der Frontscheibe und der Dicke der Klebeschicht zwischen Frontscheibe und Kunststoffträger. Der hybrid aufgebaute Kunststoffträger liefert einen erheblichen Teil der mechanischen Stabilität des Solarmoduls. Die Frontscheibe besteht aus einem Material mit einer signifikanten Biegesteifigkeit. So besitzt z. B. PMMA bei gleicher Dicke und etwa gleicher Dichte eine um etwa den Faktor 10 höhere Biegesteifigkeit als transparentes Polyurethan. Durch die ganzflächige Verklebung von Frontscheibe und Kunststoffträger durch die Klebeschicht trägt auch die biegesteife Frontscheibe mit zur mechanischen Stabilität des Solarmoduls bei. Dies hat zur Folge dass auch der Kunststoffträger zumindest mit der darin integrierten elektrischen Anschlussstruktur auf der Rückseite deutlich dünner ausgeführt werden kann als wenn die Frontseite (wie im Falle von Polyurethan) nicht mit zur Stabilität beitragen würde, was wiederum erhebliche Vorteile in der Wärmeableitung und im Gewicht - die Dichte von Polyurethan und PMMA sind etwa gleich - zur Folge hat.

Durch die die direkte Verklebung von Frontscheibe und Kunststoffträger rückt die die Solarzellen enthaltende Klebeschicht zwischen Frontscheibe und Kunststoffträger näher an die neutrale Biegelinie bzw. neutrale Faser heran, was zu geringeren mechanischen Spannungen in der Klebeschicht und damit auch in den Solarzellen führt und auf Grund des niedrigeren Lastniveaus eine deutlich höhere Lebensdauer erwarten lässt.

Als weiterer Vorteil sei genannt, dass durch die geringeren mechanischen Spannungen in der neutralen Biegelinie nicht nur elastische Verklebungen, sondern auch strukturelle Verklebungen mit weniger weichen, nicht-elastomerartigen Klebstoffen eingesetzt werden können, was wiederum zu deutlich höheren Biegesteifigkeiten und Biegefestigkeiten führt. Insbesondere die elektrische Anschlussstruktur dient mit ihren vorzugsweise verteilt innerhalb der Rückseitenkonstruktion angeordneten, freien Kontaktflächen, neben der elektrischen Kontaktierung einer exakten räumlichen Anordnung der Solarzellenanordnung relativ zur Rückseitenkonstruktion und vor allem einer Positionierung innerhalb der neutralen Fase des Solarmoduls.

Durch die Formgebung des Kunststoffträgers durch Spritzguss, Spritzprägen oder Pressen erfolgt dessen Herstellung mit den für diese Technologien üblichen niedrigen Taktzeiten im Bereich zwischen wenigen Minuten bis unter einer Minute. Geeignete Materialien für den Kunststoffträger sind z. B. PBT, PET, PA, PMMA, PC, PP oder Biopolymere wie PLA oder PLA-Copolymere, vorzugsweise mit Verstärkungsfasern, z. B. Glasfasern oder Carbonfasem oder anderen Verstärkungsfasern oder Füllstoffen oder Gemischen aus vorgenannten, zur Verbesserung der mechanischen Eigenschaften, insbesondere der Steifigkeit und Festigkeit. Die Einarbeitung der vorgenannten Fasern erfolgt mit dem Fachmann bekannten Compoundier-Technologien, entweder in einem der Formgebung vorgelagerten separaten Prozessschritt oder inline im gleichen Prozessschritt wie die Formgebung mit der Spritzgieß-Compoundier-Technologie.

Der Kunststoff für den Träger kann zusätzlich mit einem Füllstoff ausgerüstet werden, der die Wärmeleitfähigkeit erhöht, z. B. metallische Fasern oder pulverförmiges Kupfer. Des Weiteren kann er mit einem Füllstoff zur Reduzierung der Wärmeausdehnung des ungefüllten Polymers wie Kreide, Glasplättchen oder Silikaten ausgerüstet werden. Die Einarbeitung der vorgenannten Füllstoffe erfolgt mit dem Fachmann bekannten Compoundier-Technologien, entweder in einem der Formgebung vorgelagerten separaten Prozessschritt oder inline im gleichen Prozessschritt wie die Formgebung mit der Spritzgieß-Compoundier-Technologie.

In vorteilhafter Weise werden den Kunststoffträger im Prozess der Formgebung mittels Spritzgießen, Spritzprägen oder Pressen die elektrische Anschlusstruktur, d.h. die elektrischen Zuleitungen von den Kontakten für die elektrische Kontaktierung der Solarzellen zur Anschlussdose für die externen Anschlüsse integriert, z. B. durch Einbringen der metallischen Leiter in die Kavität für den Kunststoffträger vor dem Einspritzvorgang oder durch einen 3D-MID-Prozess (MID = Molded Interconnected Devices). Die für die Integration der elektrischen Anschlussstruktur, wie Leitbahnen in spritzgegossene Kunststoffteile geeigneten Technologien sind in der Kunststoffverarbeitung bekannt.

Im Prozess der Formgebung für den Kunststoffträger kann auch die Anschlussdose mit ausgeformt werden, z. B. aus dem gleichen Kunststoff der Träger, oder unter Einsatz des Mehrkomponentenspritzgusses aus einem anderen Kunststoff. Die für die Ausformung der Anschlussdose und die Abdichtung des Kabels von den Solarzellen zur Anschlussdose erforderlichen Werkzeug- und Spritzgießtechnologien sind in der Kunststoffverarbeitung bekannt.

Auf die der Frontseite zugewandten Seite der Rückseitenkonstruktion können weitere Schichten aufgetragen werden, z. B. eine IR-reflektierende Kunststoffschicht zur besseren Nutzung des eingestrahlten Lichtes zur Erhöhung des Wirkungsgrades oder als Barriereschichten. Die Schichten können auf den Träger entweder nach der Formgebung oder im Prozess der Formgebung im Werkzeug mit in der Kunststoffverarbeitung bekannten Technologien aufgebracht werden, z. B. dem Inmold-Coating oder einem Sprühauftrag oder dem Überfluten mit einem Reaktivpolymer im Werkzeug oder durch das Einlegen und Hinterspritzen von Folien im Werkzeug vor dem Einspritzen des Kunststoffes für den Träger.

In einer bevorzugten Ausführungsform enthält die Rückseitenkonstruktion auch Befestigungselemente zur späteren Montage, die als Einlegeteile (Inserts) in die Werkzeug-Kavität eingebracht und auf diese Weise bei der Formgebung kraftschlüssig in den Träger integriert werden können. Die Befestigungselemente werden dabei vor dem Umspritzen in einer dem Fachmann geläufigen Weise im Werkzeug an den entsprechenden Stellen positioniert. Die für Inserts erforderlichen Technologien sind in der Kunststoffverarbeitung bekannt. Auch die Inserts können zusätzliche, bei entsprechender Ausbildung und Einbettung in die Rückseitenkonstruktion, zusätzliche Stützwirkung und die Festigkeit der Rückseitenkonstruktion verbessernde Auswirkungen entfalten

Nach der Herstellung der Rückseitenkonstruktion werden die Solarzellen auf den Träger aufgelegt und deren Anschlüsse mit den Kontaktstellen der in dem Träger integrierten elektrischen Anschlussstruktur, wie elektrische Zuleitungen zur Anschlussdose verbunden. Die Solarzellen können vor dem Aufbringen auf den Träger unverschaltet oder bereits teilweise verschaltet sein, z. B. bei waferbasierten Zellen in Form von Strings, oder vollständig verschaltet, z. B. als verschalteter Dünnschichtmodul oder bei waferbasierten Zellen als vorkonfektionierte Folie mit den darauf aufgebrachten, kontaktierten Solarzellen, die die Leitbahnen für die Verschaltung der einzelnen Zellen untereinander enthält.

In einer vorteilhaften Ausführung enthält die Rückseitenkonstruktion an den Stellen, an die die Zellen platziert werden, eine Berandung bzw. steg- oder rippenartig ausgebildete Abstützstrukturen für jede Zelle, die eine Fixierung der Zellen ermöglicht. Dabei kann es sich entweder um eine Vertiefung handeln, in die die Zellen eingelegt werden, oder um eine kleine Erhöhung an den Rändern jeder Zelle. Außerdem ist die Oberfläche der Rückseitenkonstruktion an den Stellen, an denen die Zellen auf der Rückseitenkonstruktion aufliegen, so strukturiert, dass die Zellen nicht flächig am anliegen, um so beim späteren Einbringen des Klebstoffs in den Zwischenraum zwischen Scheibe und Rückseitenkonstruktion für deren Verklebung das vollständige Umfließen der Zellen sicher zu stellen.

Die Verbindung der elektrischen Anschlüsse der Solarzellenanordnung mit den Kontakten auf der Rückseitenkonstruktion sowie den Zuleitungen zur Anschlussdose für die externen Anschlüsse erfolgt durch dem Fachmann bekannte Verbindungstechniken wie Löten, Drahtbonden oder anderen üblichen Technologien. Alternativ kann die elektrische Verbindung der elektrischen Anschlüsse der Solarzellen mit den Kontakten auf der Rückseitenkonstruktion durch leitfähige Klebstoffe hergestellt werden. In diesem Fall bildet der Klebstoff, der zunächst auf die Kontakte auf dem Kunststoffträger aufgetragen wird und nach der Kontaktierung mit den elektrischen Anschlüssen der photoaktiven Elemente aushärtet, das Lot. Mit leitfähigen Klebstoffen können waferbasierte, unverschaltete rückseitenkontaktierte Solarzellen ohne weitere Verdrahtung direkt mit den Kontakten auf der Rückseitenkonstruktion kontaktiert werden, so dass die einzelnen Solarzellen durch das Fehlen weiterer Verdrahtung dichter nebeneinander angeordnet werden und so die Ausbeute pro Fläche erhöht werden kann.

Anstelle der bevorzugten Verwendung von thermoplastisch bzw. duroplastisch verarbeitbaren Kunststoffen als Grundmaterial für den Aufbau der Rückseitenkonstruktion sind auch organische oder keramische Werkstoffe als Grundmaterial für die Rückseitenkonstruktion geeignet, in die elektrische Anschlussstrukturen integriert sind für die elektrische Verbindung der Solarzellenanordnung untereinander sowie auch für den elektrischen Anschluss des Solarmoduls zu einem externen Verbraucherstromkreis zur Stromabnahme.

Auch in diesem Falle ist zumindest ein Teilbereich der elektrischen Anschlussstruktur vollständig von dem organischen oder keramischen Werkstoff umgeben und zumindest ein anderer Teilbereich der Anschlussstruktur weist einen der Solarzellenanordnung zugewandten freien Kontaktbereich sowie einen freien Kontaktbereich oder eine elektrische Leitung für den Anschluss des Moduls nach außen zur Stromabnahme auf.

Neben der elektrischen Anschlussstruktur ist innerhalb der aus organischen oder keramischen Werkstoff gefertigten Rückseitenkonstruktion eine Stützstruktur zumindest teilweise integriert, die aus Glas, Keramik oder einem Kunststoff, vorzugsweise mit Fasern verstärkt, besteht. Denkbar wäre auch eine aus Metall gefertigte Stützstruktur, die zugleich als Teilbereich der elektrischen Anschlussstruktur für die elektrische Verbindung der Solarzellenanordnung untereinander und der Solarzellenanordnung mit den elektrischen Anschlüssen des Moduls nach außen zur Stromabnahme fungiert.

Je nach Materialwahl und Ausbildung der Stützstruktur bietet es sich an zumindest Teilbereiche der Stützstruktur als einzelne oder zusammenhängende Profile, in Form von Strängen, Bändern oder Gittergeflechten auszubilden, die, sich einander berührend oder sich einander nicht berührend, in der Materialmatrix der Rückseitenkonstruktion vorliegen.

Auf der Frontseite des Solarmoduls befindet sich die Frontscheibe. Die Dicke der Frontscheibe liegt im Bereich zwischen einigen Zehntel Millimetern und einigen Millimetern. Die Frontscheibe besteht vorzugsweise aus einem transparenten Kunststoff, z. B. auf der Basis von PMMA.

Bei Dünnschichtzellen, die in der Regel bereits auf eine Scheibe, z. B. aus Glas, Kunststoff, Glaskeramik oder Keramik, abgeschieden werden, ist diese Scheibe die Frontscheibe des Moduls.

In einer vorteilhaften Ausführung können zur Verringerung des reflektierten Anteils des einstrahlenden Lichtes dem Fachmann bekannte Antireflexionsschichten oder Texturierungen auf die dem einstrahlenden Licht zugewandte Oberfläche der Scheibe aufgebracht werden.

In einer vorteilhaften Ausführung kann die Frontscheibe zur Erhöhung der Photonenausbeute auch mit Füllstoffen versehen werden, die die Wellenlänge des einstrahlenden Lichts konvertieren und auf diese Weise die Quantenausbeute in dem Wellenlängenbereich erhöhen, in dem die photoaktiven Zellen ihren größten Wirkungsgrad haben.

Der Zwischenraum zwischen Scheibe und Rückseitenkonstruktion wird blasenfrei mit einem Polymer ausgefüllt, das zum einen die Frontscheibe mit der Rückseitenkonstruktion verklebt und zum anderen die im Zwischenraum zwischen Rückseitenkonstruktion und Frontscheibe befindlichen photoaktiven Zellen und das Kontakt- und Leitbahnsystem vor Medieneinfluss schützt. Im Falle waferbasierter Zellen handelt es sich vorzugsweise um ein hoch transparentes, elastisches Polymer. Die Dicke des Zwischenraums liegt im Bereich einiger Zehntel Millimeter bis einiger Millimeter.

Für die Langzeitstabilität der erfindungsgemäßen Solarmodule sind die durch wechselnde Temperaturen und unterschiedliche Ausdehnungskoeffizienten der verwendeten Materialien bedingten thermischen Spannungen von besonderer Bedeutung. Diese Spannungen können zu Defekten in den Solarzellen oder am Kontakt- und Leitbahnsystem, zu einer Delaminierung zwischen Rückseitenkonstruktion und Klebeschicht oder Klebeschicht und Frontscheibe und zur Zerstörung des Modulverbunds führen. Durch den Einsatz eines elastischen Polymers der Klebeschicht werden temperaturbedingte mechanische Spannungen im Bereich zwischen Frontscheibe und Rückseitenkonstruktion weitgehend reduziert.

Durch die Verwendung einer mit niedrigen Viskositäten, z. B. bei Raumtemperatur im Bereich weniger 1000 mPas und darunter, verarbeitbaren Kunststoffkapselung, z. B. als Reaktivsystem oder als Dispersion, können dünnste Spalte von wenigen Mikrometern porenfrei gefüllt werden.

Das Polymer der Kunststoffkapselung kann entweder zuerst auf der Rückseitenkonstruktion mit den elektrisch kontaktierten Solarzellen aufgetragen und danach die Frontscheibe aufgelegt werden. Für den Auftrag des Polymers der Kunststoffkapselung auf die Rückseitenkonstruktion eignet sich z. B. ein druckloses Gießverfahren. Die entsprechenden Technologien sind dem Fachmann bekannt.

Mittels Fixierungshilfen, z. B., eines Werkzeugs, kann aber auch zunächst die Frontscheibe in ihrer Endposition über der Rückseitenkonstruktion fixiert und danach das Polymer der Kunststoffkapselung in den Zwischenraum zwischen Frontscheibe und Rückseitenkonstruktion eingebracht werden. Hierfür können sowohl Hochdruckals auch Niederdruckverfahren eingesetzt werden. Die entsprechenden Technologien sind dem Fachmann bekannt.

Als Polymere der Kunststoffkapselung eignen sich transparente Polyurethansysteme, beispielsweise aus aliphatischen Polyisocyanaten, native Polyurea-Systeme, Gieß-Silikone, native Epoxide, Plastisole.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:

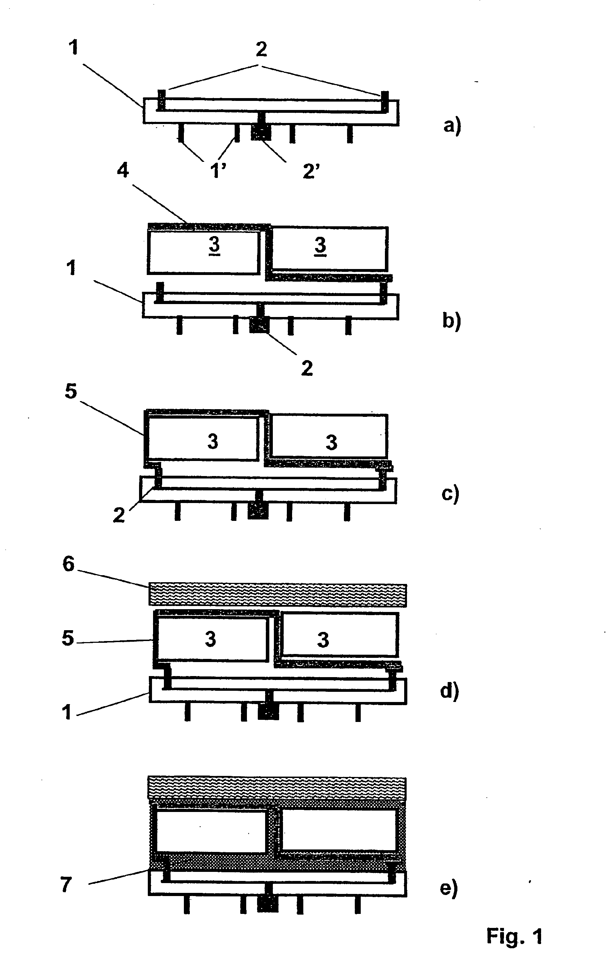

Fig. 1a-e Sequenzbilddartstellung zur Fertigung eines Solarmoduls

### Wege zur Ausführung der Erfindung, gewerbliche Verwendbarkeit

In den Figuren 1a bis sind Fertigungsschritte zur kostengünstigen Herstellung eines Solarmoduls dargestellt.

In Figur 1a ist als Rückseitenkonstruktion ein Kunststoffträger 1 dargestellt, der im Wege eines Spritzguss- oder Spritzprägeverfahrens oder im Wege eines Pressverfahrens aus einem Kunststoffmaterial hergestellt ist. Innerhalb des Kunststoffträgers 1 ist zugleich eine elektrische Anschlussstruktur 2 für die spätere elektrische Kontaktierung der Solarzellenanordnung vorgesehen. Die elektrische Anschlussstruktur 2 ist in vorteilhafter Weise zumindest in jenen Teilbereichen, in denen sie vollständig von dem Kunststoffmaterial des Kunststoffträgers 1 ummantelt ist, weitgehend biegesteif ausgebildet, bspw. durch Profilierung als Schienen, so dass der Kunststoffträger durch die eingebettete elektrische Anschlussstruktur 2 eine verbesserte Flächensteifigkeit erfährt. Zudem verfügt der Kunststoffträger 1 rückseitig über rippenartige Verstrebungen 1', die einerseits zur weiteren Stabilisierung sowie auch zur Befestigung des Solarmoduls dienen. Nicht notwendigerweise sind die Verstrebungen 1' aus dem gleichen Material zu fertigen aus dem der Kunststoffträger 1 besteht. Ebenso bietet es sich an Glas, Keramik, Metall, faserverstärkte Verbundwerkstoffe oder ähnlich, steife Materialen einzusetzen und diese zumindest teilweise integral in den Kunststoffträger einzuarbeiten.

Die elektrische Anschlussstruktur 2 weist rückseitig zum Kunststoffträger 1 eine zentrale Anschlussdose 2' auf, über die das fertig gestellte Solarmodul mit einer externen Ansteuer- und Versorgungseinheit verbunden werden kann. Auch die Anschlussdose 2 ist zumindest teilweise in den Kunststoffträger 1 integral eingebunden.

Im Fertigungsschritt gemäß Figur 1b wird eine Reihe ("String") verschalteter 4 Solarzellen 3 auf die Vorderseite des Kunststoffträgers 1 in Position gebracht und im Verfahrensschritt gemäß Figur 1c mittels elektrischer Verbindungen 5 mit der elektrischen, im Kunststoffträger 1 integrierten Anschlussstruktur 2 verbunden. Nicht im einzelnen dargestellt sind auf der Vorderseite des Kunststoffträgers 1 ausgeformte, aus Kunststoff gefertigte Aufnahmestrukturen, in die die über den Rahmen 4 verbundenen Solarzellen 3 eingepasst werden können, so dass die Solarzellen 3 in einer vordefinierten Lage relativ zum Kunststoffträger 1 zur Anlage gebracht werden können.

Im Fertigungsschritt gemäß Figur 1d wird eine strahlungstransparente, vorzugsweise aus PMMA-Material bestehende Frontscheibe 6 auf die Solarzellenanordnung 3, 4 aufgebracht, so dass sich ein Zwischenraum zwischen der Frontscheibe 6 und dem Kunststoffträger 1 bildet, der in dem in Figur 1f dargestellten Fertigungsschritt mit einer Vergussmasse 7 vollständig ausgefüllt wird. Die Vergussmasse 7 dient in Art einer Klebschicht, durch die die Frontscheibe 6 mit dem Kunststoffträger 7 innig derart verbunden wird, so dass die Vergussmasse 7 mechanische Lasten entsprechend zu übertragen in der Lage ist. Die Vergussmasse 7 umschließt zugleich die innen liegende Solarzellenanordnung 3+4 hermetisch vollständig, d. h. auch die Seitenflanken der Solarzellenanordnung sind mit der Vergussmasse 7 umschlossen.

Das lösungsgemäß ausgebildete Solarmodul weist somit folgende Vorteile auf:

Durch den Aufbau des Solarmoduls aus einem separaten Träger und einer separaten Frontscheibe, die durch ein Einbettungsmaterial flächig miteinander verklebt werden, tragen beide zur Biegesteifigkeit bei. Hinzukommt der Beitrag zur Biegefestigkeit durch die elektrische Anschlussstruktur und gegebenenfalls der zusätzlichen Stützstruktur, die jeweils zumindest als teilweise integrale Bestandteile der Rückseitenkonstruktion ausgebildet sind.

Für den Kunststoffträger können spritzgießbare thermoplastische, bzw. duroplastische Kunststoffe verwendet und dieser mit einer hohen Biegesteifigkeit und Biegefestigkeit ausgebildet werden.

Die Frontscheibe wird aus einem strahlungstransparenten Material hergestellt, vorzugsweise aus Kunststoff auf Basis von PMMA, das nachgewiesener Weise eine hohe Langzeit-UV-Stabilität, eine niedrige Dichte und eine hohe Biegesteifigkeit besitzt.

Die Frontscheibe sowie der Kunststoffträger mit der dazwischen liegenden Solarzellenanordnung werden im Wege eines spannungsarmen Gießprozesses miteinander verklebt, so dass eine hohe Langzeitbeständigkeit selbst unter wechselnden Einsatzbedingungen im Bezug auf Temperaturschwankungen und mechanische Belastungen garantiert wird.

Die Fertigungszeit der Herstellung des lösungsgemäßen Solarmoduls kann durch entsprechende Entkoppelung der Fertigung von Front- und Kunststoffträgerseite erheblich verkürzt werden.

### Bezugszeichenliste

- 1: Kunststoffträger
- 1': Rippenzüge
- 2: Elektrische Anschlussstruktur
- 2': Anschlussdose
- 3: Solarzellen
- 4: Rahmenelemente
- 5: Elektrische Verbindungsstruktur
- 6: Frontscheibe
- 7: Vergussmasse

## Patentansprüche

1. Solarmodul mit einer flächig ausgebildeten Solarzellenanordnung (3), an deren Rückseite eine Rückseitenkonstruktion und an deren Vorderseite eine strahlungstransparente Frontscheibe (6) vorgesehen sind, mit einer die Solarzellenanordnung (3) zwischen Rückseitenkonstruktion und Frontscheibe (6) umgebenden, erstarrungsfähigen und mechanische Lasten übertragenden Vergussmasse (7), die die Frontscheibe (6) mit ihrer der Rückseitenkonstruktion zugewandten Oberfläche ganzflächig mit der Rückseitenkonstruktion verbindet und die Solarzellenanordnung (3) vollständig umschließt, wobei die Rückseitenkonstruktion als separates Modul ausgebildet ist, wobei die Rückseitenkonstruktion in Form eines mittels Spritzgießen, Spritzprägen oder Pressen hergestellten Kunststoffträgers (1) ausgebildet ist, der Kunststoffträger (1) eine in den Kunststoffträger (1) integrierte, metallische elektrische Anschlussstruktur (2) für eine elektrische Verbindung mit der Solarzellenanordnung (3) derart vorsieht, dass zumindest ein Teilbereich der elektrischen Anschlussstruktur (2) vollständig von dem Kunststoffträgermaterial umgeben ist und zumindest ein anderer Teilbereich der elektrischen Anschlussstruktur (2) einen der Solarzellenanordnung (3) zugewandten freien Kontaktbereich aufweist,
**dadurch gekennzeichnet, dass** die Solarzellenanordnung (3) zwischen der Frontscheibe (6) und der Rückseitenkonstruktion längs oder nahe dem Bereich der sich bei Durchbiegung des Solarmoduls einstellenden neutralen Biegeebene angeordnet ist.

2. Solarmodul mit einer flächig ausgebildeten Solarzellenanordnung (3), an deren Rückseite eine Rückseitenkonstruktion und an deren Vorderseite eine strahlungstransparente Frontscheibe (6) vorgesehen sind, mit einer die Solarzellenanordnung (3) zwischen Rückseitenkonstruktion und Frontscheibe (6) umgebenden, erstarrungsfähigen und mechanische Lasten übertragenden Vergussmasse (7), die die Frontscheibe (6) mit ihrer der Rückseitenkonstruktion zugewandten Oberfläche ganzflächig mit der Rückseitenkonstruktion verbindet und die Solarzellenanordnung (3) vollständig umschließt, wobei die Rückseitenkonstruktion als separates Modul ausgebildet ist, wobei die Rückseitenkonstruktion in Form eines biegesteifen keramischen oder organischen Flächenelementes ausgebildet ist und in die Rückseitenkonstruktion eine metallische elektrische Anschlussstruktur (2) für eine elektrische Verbindung mit der Solarzellenanordnung (3) derart integriert ist, dass zumindest ein Teilbereich der elektrischen Anschlussstruktur (2) vollständig von dem Material der Rückseitenkonstruktion umgeben ist und zumindest ein anderer Teilbereich der Anschlussstruktur (2) einen der Solarzellenanordnung (3) zugewandten freien Kontaktbereich aufweist,
**dadurch gekennzeichnet, dass** die Solarzellenanordnung (3) zwischen der Frontscheibe (6) und der Rückseitenkonstruktion längs oder nahe dem Bereich der sich bei Durchbiegung des Solarmoduls einstellenden neutralen Biegeebene angeordnet ist.

3. Solarmodul nach Anspruch 1 oder 2,
**dadurch gekennzeichnet, dass** die Frontscheibe (6) aus Glas, Glaskeramik, oder aus einem transparentem Kunststoff, vorzugsweise ein PMMA basierender Kunststoff, besteht.

4. Solarmodul nach einem der Ansprüche 1 oder 3,
**dadurch gekennzeichnet, dass** der Kunststoffträger (1) aus einem thermoplastischen Kunststoff gefertigt ist, vorzugsweise aus PBT, PET, PA, PMMA, PC, PP, Biopolymere, insbesondere PLA, PLA-Copolymere besteht, oder aus einem duroplastischen Kunststoff, insbesondere aus einem SMC gefertigt ist, vorzugsweise aus Phenol-, Polyester oder Epoxydharzen besteht.

5. Solarmodul nach einem der Ansprüche 1, 3 bis 4,
**dadurch gekennzeichnet, dass** der Kunststoffträger (1) einen faserverstärkten Kunststoff aufweist.

6. Solarmodul nach einem der Ansprüche 1, 3 bis 5,
**dadurch gekennzeichnet, dass** der Kunststoffträger (1) Füllstoffe enthält, wie Metallpulver, Kreide, Glasplättchen, Silikate.

7. Solarmodul nach einem der Ansprüche 1 bis 6,
**dadurch gekennzeichnet, dass** eine elektrische Verbindung zwischen der Solarzellenanordnung (3) und der in der Rückseitenkonstruktion vorgesehenen, elektrischen Anschlussstruktur (2) durch direkten elektrischen Kontakt, mittels elektrischem Leitkleber, Drahtbonden und/oder mittels Löt- oder Schweißverbindung erfolgt.

8. Solarmodul nach einem der Ansprüche 1 bis 7,
**dadurch gekennzeichnet, dass** die Rückseitenkonstruktion auf der der Solarzellenanordnung (3) zugewandten Seite eine Aufnahme- und/oder Fixierstruktur für die Solarzellenanordnung (3) aufweist.

9. Solarmodul nach einem der Ansprüche 1 bis 8,
**dadurch gekennzeichnet, dass** die Frontscheibe (6) die Wellenlänge der auf die Frontscheibe (6) einfallenden Strahlung konvertierende Stoffe derart enthält, dass die in der Wellenlänge konvertierte Strahlung einen höheren Wirkungsgrad in der Solarzellenanordnung (3) erzielt als die nicht konvertierte Strahlung.

10. Solarmodul nach einem der Ansprüche 1 bis 9,
**dadurch gekennzeichnet, dass** die Solarzellenanordnung (3) eine Dünnschichtsolarzelle mit einer strahlungstransparenten Deckschicht ist, und dass die Deckschicht der Solarzellenanordnung (3) als Frontscheibe (6) dient, die zumindest im randnahen Oberflächenbereich von der strahlungstransparenten Vergussmasse (7) umschlossen ist und eine Last übertragende Verbindung mit der Rückseitenkonstruktion herstellt.

11. Solarmodul nach einem der Ansprüche 1 bis 10
**dadurch gekennzeichnet, dass** die elektrische Anschlussstruktur (2) auf der der Solarzellanordnung (3) zugewandten Oberfläche der Rückseitenkonstruktion stab-, steg- oder rippenartig überragende Stützelemente vorsieht, mit denen die Solarzellenanordnung (3) lokal in elektrischen und/oder abstützenden Kontakt tritt.

12. Solarmodul nach einem der Ansprüche 1 bis 11,
**dadurch gekennzeichnet, dass** die elektrische Anschlussstruktur (2) innerhalb der Rückseitenkonstruktion als integraler Bestandteil bandförmig, gitterförmig und/oder strangprofilartig ausgebildete Teilbereiche aufweist, durch die die mechanische Stabilität der Rückseitenkonstruktion erhöht wird.

13. Solarmodul nach einem der Ansprüche 1 bis 12,
**dadurch gekennzeichnet, dass** die Rückseitenkonstruktion eine Stützstruktur aus einem Material aufweist, das sich vom Material der Rückseitenkonstruktion unterscheidet, und
dass zumindest ein Teilbereich der Stützstruktur vollständig vom Material der Rückseitenkonstruktion umgeben ist.

14. Solarmodul nach Anspruch 13,
**dadurch gekennzeichnet, dass** die Stützstruktur aus einem oder mehreren der nachfolgenden Materialien besteht: Metall, Glas, Keramik, Kunststoff oder faserverstärkter Verbundwerkstoff.

15. Solarmodul nach Anspruch 13 oder 14,
**dadurch gekennzeichnet, dass** zumindest Teilbereiche der Stützstruktur als einzelne oder zusammen hängende, stab-, band- oder gitterförmige Profile ausgebildet sind.

16. Solarmodul nach einem der Ansprüche 13 bis 15,
**dadurch gekennzeichnet, dass** zumindest ein Teilbereich einer metallischen Stützstruktur zugleich als Teilbereich der elektrischen Anschlussstruktur (2) für die elektrische Verbindung der Solarzellenanordnung (3) untereinander und der Solarzellenanordnung (2) mit elektrischen Anschlüssen nach außen zur Stromabnahme fungiert.

## Claims

1. A solar module having a flatly implemented solar cell configuration (3), on whose rear side a rear side construction is provided and on whose front side a radiation-transparent front pane (6) is provided, having a grouting compound (7), which encloses the solar cell configuration (3) between rear side construction and front pane (6), is capable of solidifying, and transmits mechanical loads, and which connects the surface of the front pane (6) facing toward the rear side construction over its entire area to the rear side construction and completely encloses the solar cell configuration (3), wherein said rear side construction is formed as a separate module and wherein the rear side construction is implemented as a separate module in the form of a plastic carrier (1) produced using injection molding, injection-compression molding, or compression, and wherein the plastic carrier (1) provides a metal electrical terminal structure (2), which is integrated in the plastic carrier, for an electrical connection to the solar cell configuration (3) in such a manner that at least one section of the electrical terminal structure (2) is completely enclosed by the plastic carrier material and at least one other section of the electrical terminal structure (2)has a free contact area facing toward the solar cell configuration (3), **characterized in that** the solar cell configuration (3) is situated between the front pane (6) and the rear side construction along or close to the area of the neutral bending plane resulting in the event of sag of the solar module.

2. A solar module having a flatly implemented solar cell configuration (3), on whose rear side a rear side construction is provided and on whose front side a radiation-transparent front pane (6) is provided, having a grouting compound (7), which encloses the solar cell configuration between rear side construction and front pane, is capable of solidifying, and transmits mechanical loads, and which connects the surface of the front pane (6) facing toward the rear side construction over its entire area to the rear side construction and completely encloses the solar cell configuration (3), wherein said rear side construction is formed as a separate module and wherein the rear side construction is implemented as a separate module, in the form of a stiff ceramic or organic planar element, and a metal electrical terminal structure for an electrical connection to the solar cell configuration (3) is integrated in the rear side construction in such a manner that at least one section of the electrical terminal structure is completely enclosed by the material of the rear side construction and at least one other section of the terminal structure (2)has a free contact area facing toward the solar cell configuration (3), **characterized in that** the solar cell configuration (3) is situated between the front pane (6) and the rear side construction along or close to the area of the neutral bending plane resulting in the event of sag of the solar module.

3. The solar module according to Claim 1 or 2,
**characterized in that** the front pane (6) comprises glass, glass-ceramic, or a transparent plastic, preferably a PMMA-based plastic.

4. The solar module according to one of Claims 1 or 3, **characterized in that** the plastic carrier (1) is manufactured from a thermoplastic, and preferably comprises PBT, PET, PA, PMMA, PC, PT, biopolymers, in particular PLA, PLA copolymers, or is manufactured from a duroplastic, in particular from an SMC, and preferably comprises phenol, polyester, or epoxide resins.

5. The solar module according to one of Claims 1, 3 through 4,
**characterized in that** the plastic carrier (1) has a fiber-reinforced plastic.

6. The solar module according to one of Claims 1, 3 through 5,
**characterized in that** the plastic carrier (1) contains fillers, such as metal powder, chalk, glass lamina,
silicates.

7. The solar module according to one of Claims 1 through 6,
**characterized in that** an electrical connection is performed between the solar cell configuration (3) and the electrical terminal structure (2) provided in the rear side construction by direct electrical contact using electrically conductive adhesives, wire bonding, and/or using soldered or welded bonds.

8. The solar module according to one of Claims 1 through 7,
**characterized in that** the rear side construction has a receptacle and/or fixing structure for the solar cell configuration (3) on the side facing toward the solar cell configuration (3).

9. The solar module according to one of Claims 1 through 8,
**characterized in that** the front pane (6) contains materials which convert the wavelength of the radiation incident on the front pane (6) in such a manner that the radiation converted in the wavelength achieves a higher efficiency in the solar cell configuration (3) than the non-converted radiation.

10. The solar module according to one of Claims 1 through 9,
**characterized in that** the solar cell configuration (3) is a thin-film solar cell having a radiation-transparent cover layer, and the cover layer of the solar cell configuration (3) is used as the front pane (6), which is enclosed at least in the surface area close to the edge by the radiation-transparent grouting compound (7) and produces a load-transferring connection to the rear side construction.

11. The solar module according to one of Claims 1 through 10,
**characterized in that** the electrical terminal structure (2) provides protruding support elements like bars, webs, or ribs on the surface of the rear side construction facing toward the solar cell configuration, with which the solar cell configuration has local electrical and/or supporting contact.

12. The solar module according to one of Claims 1 through 11,
**characterized in that** the electrical terminal structure (2) has sections implemented as strip-shaped, latticed, and/or extruded profiles as an integral component within the rear side construction, by which the mechanical stability of the rear side construction is elevated.

13. The solar module according to one of Claims 1 through 12,
**characterized in that** the rear side construction has a support structure made of a material which differs from the material of the rear side construction, and at least one section of the support structure is completely enclosed by the material of the rear side construction.

14. The solar module according to Claim 13,
**characterized in that** the support structure comprises one or more of the following materials: metal, glass, ceramic, plastic, or fiber-reinforced composite material.

15. The solar module according to Claim 13 or 14,
**characterized in that** at least sections of the support structure are implemented as individual or coherent profiles in the form of bars, strips, or lattices.

16. The solar module according to one of Claims 13 through 15,
**characterized in that** at least one section of a metal support structure also functions as a section of the electrical terminal structure (2) for the electrical connection of the solar cell configuration (3) among one another and the solar cell configuration (3) to electrical terminals to the outside for current collection.

## Revendications

1. Module solaire avec un système de cellules solaires (3) constitué en nappe à l'arrière duquel une construction arrière et à l'avant duquel une plaque avant (6) transparente au rayonnement, sont prévues, avec une masse de remplissage (7), entourant le système de cellules solaires (3) entre la construction arrière et la plaque avant (6), solidifiable et transmettant des charges mécaniques qui relie la plaque avant (6) sur toute la surface avec la construction arrière avec sa surface tournée vers la construction arrière et qui entoure complètement le système de cellules solaires (3) pour lequel la construction arrière est constituée en tant que module séparé, pour lequel la construction arrière est constituée sous la forme d'un support en matière plastique (1) fabriqué par moulage par injection, moulage par injection-estampage ou par moulage par compression, le support en plastique (1) prévoit une structure de raccord (2) électrique métallique intégrée dans le support plastique (1) pour une connexion électrique avec le système de cellules solaires (3) de telle sorte qu'au moins une zone partielle de la structure de raccord (2) électrique est complètement entourée par le matériau du support plastique et qu'au moins une autre zone partielle de la structure de raccord (2) électrique présente une zone de contact libre tournée vers le système de cellules solaires (3) **caractérisé en ce que** le système de cellules solaires (3) est disposé entre la plaque avant (6) et la construction arrière le long ou près de la zone du plan de flexion neutre s'établissant lors du fléchissement du module solaire.

2. Module solaire avec un système de cellules solaires (3) constitué en nappe à l'arrière duquel une construction arrière et à l'avant duquel une plaque avant (6) transparente au rayonnement, sont prévues, avec une masse de remplissage (7), entourant le système de cellules solaires (3) entre la construction arrière et la plaque avant (6), solidifiable et transmettant des charges mécaniques qui relie la plaque avant (6) sur toute a surface avec la construction arrière avec sa surface tournée vers la construction arrière et qui entoure complètement le système de cellules solaires (3) pour lequel la construction arrière est constituée en tant que module séparé, pour lequel la construction arrière est constituée sous la forme d'un élément de surface céramique ou organique rigide à la flexion et une structure de raccord (2) électrique métallique pour une connexion électrique avec le système de cellules solaires (3) est intégrée dans la construction arrière de telle sorte qu'au moins une zone partielle de la structure de raccord (2) électrique est complètement entourée du matériau de la construction arrière et qu'au moins une autre zone partielle de la structure de raccord (2) présente une zone de contact libre tournée vers le système de cellules solaires (3) **caractérisé en ce que** le système de cellules solaires (3) est disposé entre la plaque avant (6) et la construction arrière le long ou près de la zone du plan de flexion neutre s'établissant lors du fléchissement du module solaire.

3. Module solaire selon la revendication 1 ou 2 **caractérisé en ce que** la plaque avant (6) est en verre, en vitrocéramique ou en matière plastique transparente, de préférence une matière plastique à base de polyméthylmétacrylate (PMMA).

4. Module solaire selon une des revendications 1 ou 3 **caractérisé en ce que** le support en plastique (1) est fabriqué à partir d'une matière synthétique thermoplastique, de préférence en téréphtalate de polybutylène (TPBP), en polyéthylène téréphtalate (PETP), en polyamide (PA), en polyméthylmétacrylate (PMMA), en polycarbonate (PC), en polypropylène (PP), en biopolymère, en particulier en acide polylactique (APL), en copolymère d'APL ou à partir d'une matière synthétique thermodurcissable, en particulier à partir d'un préimprégné, de préférence en résine phénolique, résine polyester ou résine époxyde.

5. Module solaire selon une des revendications 1, 3 à 4 **caractérisé en ce que** le support en plastique (1) comporte une matière plastique renforcée à la fibre.

6. Module solaire selon une des revendications 1, 3 à 5 **caractérisé en ce que** le support en plastique (1) contient des matières de remplissage comme de la poudre métallique, de la craie, des paillettes de verre, des silicates.

7. Module solaire selon une des revendications 1 à 6 **caractérisé en ce qu'**une connexion électrique entre le système de cellules solaires (3) et la structure de raccord (2) électrique prévue dans la construction arrière est réalisée par contact électrique direct au moyen d'une matière adhésive électroconductrice, de microsoudages de fils et/ou au moyen de liaison par brasage ou soudage.

8. Module solaire selon une des revendications 1 à 7 **caractérisé en ce que** la construction arrière présente une structure de réception et/ou de fixation pour le système de cellules solaires (3) sur le côté tourné vers le système de cellules solaires (3).

9. Module solaire selon une des revendications 1 à 8 **caractérisé en ce que** la plaque avant (6) contient la longueur d'onde des matières convertissant le rayonnement tombant sur la plaque avant (6) de telle sorte que le rayonnement converti dans la longueur d'onde atteint un rendement dans le système de cellules solaires (3) plus élevé que le rayonnement non converti.

10. Module solaire selon une des revendications 1 à 9 **caractérisé en ce que** le système de cellules solaires (3) est une cellule solaire en couche mince avec une couche de couverture transparente au rayonnement et **en ce que** la couche de couverture du système de cellules solaires (3) sert de plaque avant (6) qui est englobée au moins dans la zone de surface proche du bord de la masse de remplissage (7) transparente au rayonnement et établit une connexion transmettant une charge avec la construction arrière.

11. Module solaire selon une des revendications 1 à 10 **caractérisé en ce que** la structure de raccord (2) électrique prévoit sur la surface tournée vers le système de cellules solaires (3) de la construction arrière, des éléments de support faisant saillie en forme de barrettes ou de nervures avec lesquels le système de cellules solaires (3) entre localement en contact électrique et/ou de support.

12. Module solaire selon une des revendications 1 à 11 **caractérisé en ce que** la structure de raccord (2) électrique présente, à l'intérieur de la construction arrière, en tant que composant intégral, des zones partielles constituées en forme de bandes, de grilles et/ou de type à profil en brins par lesquelles la stabilité mécanique de la construction arrière est augmentée.

13. Module solaire selon une des revendications 1 à 12 **caractérisé en ce que** la construction arrière présente une structure de support en un matériau qui se différencie du matériau de la construction arrière et **en ce qu'**au moins une zone partielle de la structure de support est complètement entourée du matériau de la construction arrière.

14. Module solaire selon la revendication 13 **caractérisé en ce que** la structure de support est composée d'un ou de plusieurs des matériaux suivants : métal, verre, céramique, matière plastique ou matériau composite renforcé à la fibre.

15. Module solaire selon la revendication 13 ou 14 **caractérisé en ce qu_{'}**au moins des zones partielles de la structure de support sont constituées en tant que profilés en forme de barrettes, de bandes, de grilles, suspendus séparés ou ensemble.

16. Module solaire selon une des revendications 13 à 15 **caractérisé en ce qu'**au moins une zone partielle d'une structure de support métallique fait en même temps fonction de zone partielle de la structure de raccord (2) électrique pour la connexion électrique du système de cellules solaires (3) entre elles et du système de cellules solaires (2) avec les raccords électriques vers l'extérieur pour capter le courant.
